Europäisches Patentamt

(19) European Patent Office

Office européen des brevets

(11) Publication number: **0 108 681**
**A2**

(12) # EUROPEAN PATENT APPLICATION

(21) Application number: 83402096.8

(22) Date of filing: 27.10.83

(51) Int. Cl.³: **G 11 C 17/00**

(30) Priority: 04.11.82 US 439260

(43) Date of publication of application:
16.05.84 Bulletin 84/20

(84) Designated-Contracting States:
DE FR GB IT NL

(71) Applicant: FAIRCHILD CAMERA & INSTRUMENT
CORPORATION
464 Ellis Street
Mountain View California 94042(US)

(72) Inventor: Tickle, Andrew C.
1222 Richardson Avenue
Los Altos California 94022(US)

(74) Representative: Chareyron, Lucien et al,
Schlumberger Limited Service Brevets 42, rue
Saint-Dominique
F-75340 Paris Cedex 07(FR)

(54) Bit erasable electrically erasable programmable read only memory.

(57) A bit erasable EEPROM is constructed which alleviates the problems of early termination of erasure and over-erasure. Rather than erasing the entire array at once, and thereby causing the problem of early termination of erasure and over-erasure, each cell is erased individually. In another embodiment of this invention, a group of one or more cells on a word line are erased at once with self-termination of the erase operation of each cell occurring when that cell's transistor becomes conductive, and at that time the erasure of only that cell ceases. The erasure of a particular cell ceases without effecting the erasure of operation of other cells. Therefore, the electrical erasure is self-limiting for each individual cell. In another embodiment of this invention, a group of one or more cells on a bit line are erased at once with no danger of under or over-erasure of each particular cell.

FIG. 4

BIT ERASABLE ELECTRICALLY
ERASABLE PROGRAMMABLE READ ONLY MEMORY
Andrew C. Tickle

## BACKGROUND OF THE INVENTION

### Field of the Invention

This invention relates to semiconductor memory devices and more particularly to programmable read only memory devices which are capable of being electrically erased.

### Description of the Prior Art

Semiconductor memory devices are well known in the prior art. Programmable read only memories (PROMS) comprise a plurality of cells, each cell capable of storing a single binary digit (bit). The programmable read only memory (PROM) devices are capable of being programmed (i.e. each cell set to store either a logical 1 or a logical 0) after the device has been fabricated. It is often desirable to reprogram memory devices in order to alter the data stored within the memory device. Accordingly, erasable PROM devices have been developed. One such erasable programmable read only memory (EPROM) device is erased by exposing the device to ultraviolet light for several hours to discharge (i.e. erase) the memory cells. Another type of memory device is the electrically erasable programmable read only memory (EEPROM). The use of EEPROMS is highly desirable in that inexpensive packaging may be used because the memory device need not be capable of being exposed to ultraviolet light. Furthermore, EEPROMs are more easily erased than ultraviolet erasable EPROMS, because EEPROMs are capable of being erased in a matter of seconds. One such EEPROM is disclosed in European Patent Application 81401794.3 published on 26 May 1982 with publication number 0052566 and assigned to Fairchild Camera and Instrument Corporation.

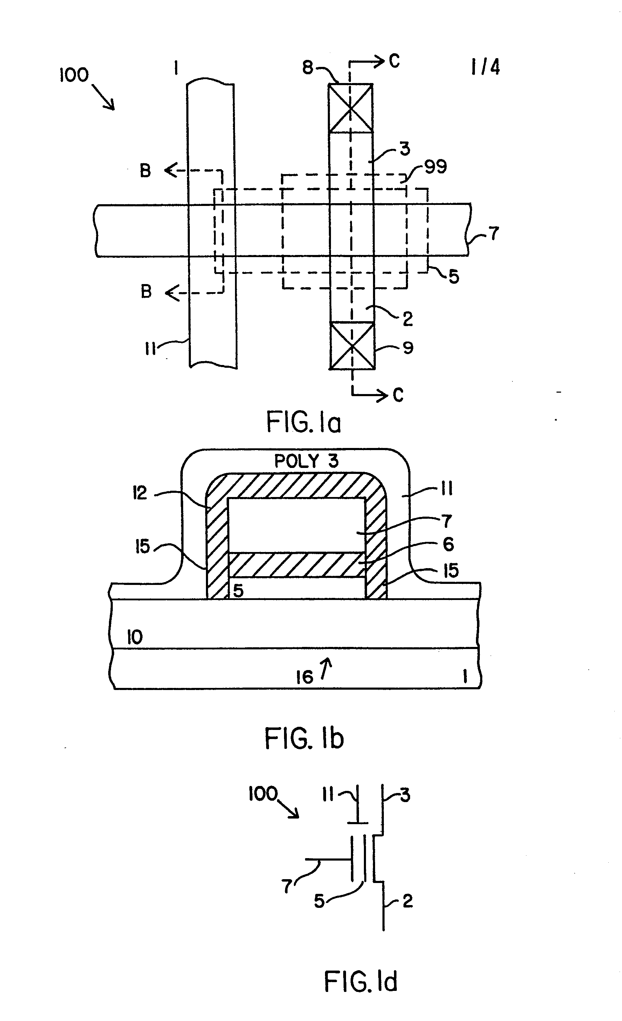

Another such EEPROM device is described by Kupec et al in an article entitled "Triple Level Poly Silicon $E^2$PROM with Single Transistor Per Bit", published in the Technical Digest of the International Electronic Devices Meeting, 1980, Washington, D.C., pages 602-606. The Kupec et al. cell structure is shown in Figures 1a-1d. As seen in Figure 1a, cell 100, is formed in a P-type substrate 1 and includes N type diffused regions 2 and 3 which form the source-drain regions of the floating gate transistor 99 of cell 100. Contact regions 9 and 8 allow electrical connection from low resistivity interconnect lines (not shown) to source-drain regions 2 and 3, respectively. Floating gate 5 is separated from substrate 1 by dielectric 10 and overlies the P type channel region 16 formed between N type source-drain regions 2 and 3. Formed above floating gate 5 is conductive word line 7 which also serves as the control gate of the transistor 99. Word line 7 is separated from floating gate 5 by dielectric 6. Erase line 11 is formed above and surrounding both floating gate 5 and word line 7. Each of the conductive layers 5, 7 and 11 are separated from the others and the substrate by insulation layers 10, 6 and 12. As will be more fully described later, floating gate 5 stores a charge, thereby establishing the control gate threshold voltage of transistor 99 and storing the desired data within memory cell 100.

Figure 1b is a cross-sectional view taken along line BB shown in Figure 1a. As shown in Figure 1b, a layer of field oxide 10 is formed on P type silicon substrate 1. Floating gate is formed on field oxide 10 and covered by insulating layer 6 (typically oxide). Word line 7 is formed above and apart from floating gate 5. Floating gate 5, oxide 6, and word line 7 are surrounded by dielectric layer 12 (again typically oxide). Erase line 11 is formed above and around oxide 12 as shown.

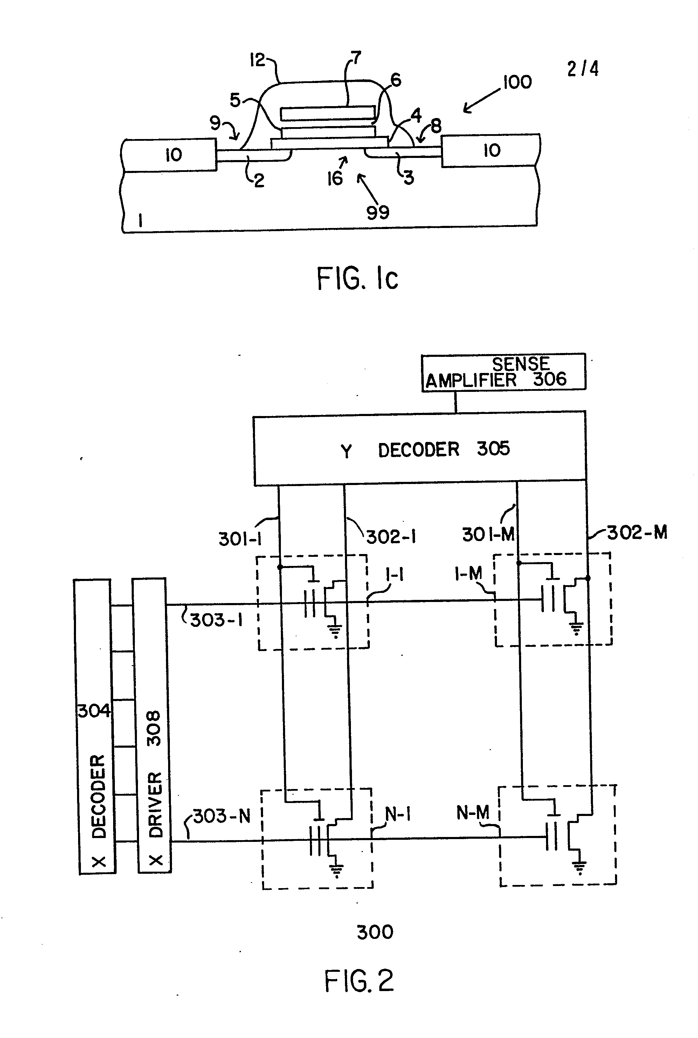

Figure 1c shows a cross-sectional view of the structure of Figure 1a taken along line CC. As shown in Figure 1c, field oxide 10 is formed on a P-type substrate 1 thereby defining the active area of the device having N-type source-drain regions 2 and 3. Gate oxide 4 is formed above the channel region located between source-drain regions 2 and 3. Floating gate 5 is formed above gate oxide 4 and covered by oxide 6, upon which word line 7 is formed. Word line 7 serves as the gate of transistor 99. Oxide 12, which serves as electrical insulation, is formed above and surrounding gate oxide 4, floating gate 5, oxide 6, and word line 7. Contact openings 8 and 9 are formed in order to allow electrical connection between low resistivity electrical leads (not shown) and source-drain regions 3 and 2, respectively.

Figure 1d shows the symbolic representation of the floating gate memory cell 100 of Figure 1a. As shown in Figure 1d, floating gate memory cell 100 includes source-drain regions 2 and 3, floating gate 5, control gate 7 and erase line 11.

Programming of cell 100 is accomplished by establishing a charge on floating gate 5, which determines the threshold voltage of transistor 99. For example, a logical 1 is defined as a low impedence between source-drain regions 2 and 3 when a voltage of approximately 5 volts is applied to control gate 7. Conversely, a logical 0 is defined as a high impedance between source-drain regions 2 and 3 when a voltage of approximately 5 volts is applied to control gate 7. Accordingly, to program a logical 0 state in cell 100, electrons are stored on floating gate 5 by conventional channel injection of hot electrons. This is accomplished, for example, by placing a high voltage (typically 10 to 20 volts) on control gate 7, placing a relatively high voltage (typically 10 to 20 volts) on source-drain region 3, and grounding source-drain region 2 and erase line 11. This causes electrons to flow to source-drain region 3 from source-drain region 2 and, in the process, some electrons are injected from the channel region 16 through gate oxide 4 to floating gate 5. During this programming of cell 100 to a logical zero, sufficient electrons are stored within floating gate 5 to bias memory cell 100 such that a 5 volt signal applied to control gate 7 will be insufficient to cause transistor 99 to turn on. Conversely, a logical 1 state is provided by the absence of electrons stored on floating gate 5, thus allowing a 5 volt signal placed on control gate 7 to cause transistor 99 to turn on.

Erasing memory cell 100 is accomplished by removing the electrons within floating gate 5, thereby returning floating gate 5 to ground potential. This erasure is accomplished, for example, by grounding source-drain region 3 and control gate 7. A high voltage (typically 10 to 20 volts) is placed on the erase line 11, thus causing electrons stored within floating gate 5 to tunnel through regions 15 of oxide 12 to erase line 11.

Figure 2 shows a typical array 300 of NxM memory cells 1-1 through N-M, where N is the number of words in the array and M is the number of bits per word. Accordingly, memory array 300 is shown having cell 1-1, providing the first bit of word 1, memory cell 1-M, providing the Mth bit of word 1, cell N-1, providing the first bit of the Nth word, and cell N-M, providing the Mth bit of the Nth word. Each of the cells 1-1 through N-M of memory array 300 comprise, for example, EEPROM cells identical to cell 100 shown in Figure 1a. Memory array 300 includes X decoder 304, X driver 308, Y decoder 305, and sense amplifier 306. X decoder 304 serves to receive a binary input word defining which word line 303-1 through 303-N is to be selected. X decoder 304 allows an X word comprising n bits to define which of the $N=2^n$ word lines 303-1 through 303-N is to be selected. X driver 308 serves to provide the appropriate voltages on the selected word lines 303-1 through 303-N, and on the remaining de selected word lines. Y decoder 305 serves the same function in decoding an m bit input word defining which of the $M=2^m$ pairs of bit lines 301-1, 302-1 through 301-M, 302-M is to be selected. Sense amplifier 306 serves, during the read operation, to determine the state of the cell being read. Naturally, as is well known to those of ordinary skill in the art, memory array 300 may include a plurality of sense amplifiers 306 thus allowing a plurality of cells along a selected word line to be read or written simultaneously, although such additional sense amplifiers are not shown in the figures for the sake of brevity.

To program the cells on a selected word line, for example word line 303-1, a high voltage is placed on the selected word line 303-1. This places a high voltage (typically 10-20 volts) on each control gate 7 of each cell 1-1 through 1-M. Those cells 1-1 through 1-M that are to be programmed to store a logical 0 have a high voltage placed on their associate bit lines 302-1 through 302-M by Y decoder 305 and those cells 1-1 through 1-M which are to be programmed to store a logical 1 have their bit lines placed at ground. The Y decoder 305 receives a signal from external circuitry (not shown) which determines which cells are to be programmed to store a logical 0 and which cells are to be programmed to store a logical 1 and selectively applies the proper potential to the bit lines 302-1 through 302-M for proper programming. Likewise, the X decoder 304 receives a similar signal, determines which word line is to have its cells programmed and, through the X driver 308, applies the appropriate voltage to the selected word line and to the remaining deselected word lines to the proper word line 303.

To read the data stored within the cells of a desired word line of array 300, for instance, word line 303-1, a potential is applied to word line 303-1. This potential is typically 2-5 volts which is sufficient to cause each cell storing a logical 1 (and which have a lower control gate threshold voltage) to turn on, but is insufficient to cause each cell storing a logical 0 (and which have a higher control gate threshold voltage to turn off). A potential is applied to each of the bit lines 302-1 to 302-M. Those cells 1-1 through 1-M which have been programmed to store a logical 1 will then be conductive, while those that are programmed to store a logical 0 will not. The sense amplifier 306 determines which cells are conductive (and therefore have grounded bit lines) and which are not and supplies this data to external circuitry (not shown). The other word lines 303-2 to 303-N are kept at ground potential, and therefore the cells along those word lines do not become conductive, regardless of the data stored in each cell and their control gate threshold voltage.

One particular problem experienced with such prior art techniques for erasing arrays of memory cells, wherein each cell in the array is erased simultaneously, is that electrical erasure of each cell is not self-limiting. In other words, in an array of a plurality of memory cells, each memory cell will not behave in an identical manner during erase. Thus, while one cell within such a memory array may be erased with a voltage of 15 volts applied to its erase line, another memory cell may not be erased with this low a voltage, and yet another memory cell may be over-erased in that sufficient electrons are withdrawn from its floating gate to place its floating gate at a positive potential rather than at ground, as desired. Thus, electrical erasure of an array of memory cells can result in the storage of undesired data within the memory array.

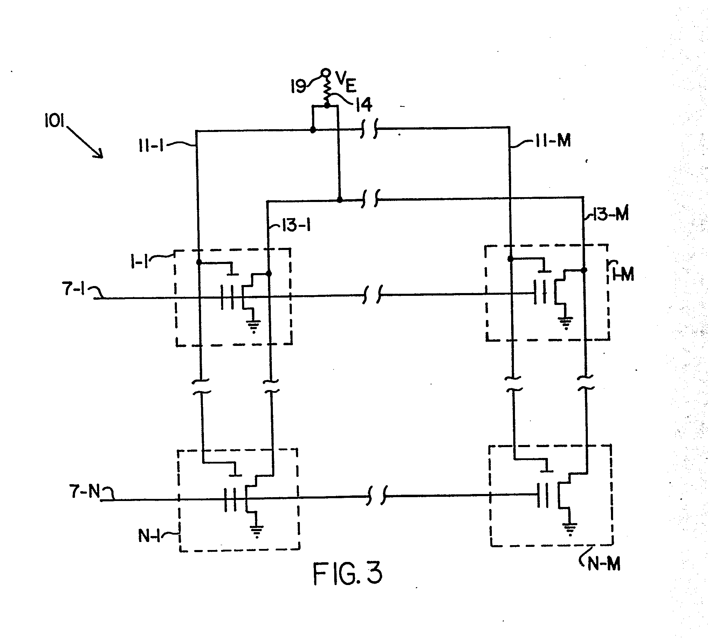

One attempt to overcome this problem created by the non-uniform nature of electrical erasure of a plurality of EEPROM cells has been discussed in the above-mentioned article of Kupec et al. An EEPROM device comprising an array of EEPROM cells constructed in accordance with the Kupec et al. article is shown in the schematic diagram of Figure 3. Figure 3 shows an array of NxM memory cells, wherein N is the number of words in the array, and M is the number of bits per word. During erasure of the Kupec et al. structure of Figure 3, the erase lines 11-1 through 11-M are connected in common with each of the bit lines 13-1 through 13-M which are in turn connected through resistor 14 to terminal 19 which is connected to the erase voltage VE. During erasure, the erase voltage VE (typically 10 to 20 volts) is applied through resistor 14 to erase lines 11 and bit lines 13. Each word line 7-1 through 7-N is held low (typically ground). The drain of each memory cell 1-1 through N-M is connected to bit line 13 and the source of each memory cell 1-1 through N-M is connected to ground. Thus, during erasure, the high voltage applied to erase lines 11-1 through 11-M causes electrons to tunnel from the floating gates of the cells 1-1 through N-M to erase lines 11-1 through 11-M respectively, thus tending to discharge the floating gates of each memory cell 1-1 through N-M of array 101. However, when a single one of memory cells 1-1 through N-M is sufficiently erased such that that cell begins to conduct (i.e. current flows from its source connected to its associated bit line through its channel to its source terminal connected to a voltage below the effective erase voltage, thereby ceasing erasure), bit lines 13-1 through 13-M are reduced in potential. Because bit lines 13-1 through 13-M and erase lines 11-1 through 11-M are connected in common during erase, erase lines 11-1 through 11-M are also reduced in potential when a single cell 1-1 through N-M is sufficiently erased to turn on. At this time, erasure of _all_ memory cells 1-1 through N-M of memory array 101 ceases, regardless of whether each memory cell 1-1 through N-M is in fact sufficiently erased. Thus, while this erasure technique prevents the over erasure of cells 1-1 through N-M, this erasure technique results in the nonsymetrical erasure of memory cells 1-1 through N-M, with the resultant aforesaid problem of undesirable data remaining stored within certain memory cells of memory array 101.

Compounding the problem of nonsymetrical erase characteristics of manufactured devices, the voltage required for erasure typically increases, often by more than a factor of 2, after repeated (approximately 10,000) write and erase cycles. Since in most operating conditions some cells of the memory array will never (or seldom) be written into, these cells will not experience any degradation in erase conditions due to tunneling currents during erasure, and therefore, these cells will, over a long period of time, retain their ability to be erased at a relatively low erase voltage. Thus, these cells will terminate the erase operation before the more heavily exercised cells, which have been repeatedly written and erased and thus have degraded erase characteristics requiring higher erase voltages, are fully erased.

SUMMARY

In accordance with this invention, a bit erasable EEPROM is constructed which alleviates the problems of early termination of erasure and over-erasure. Rather than erasing the entire array at once, and thereby causing the problem of early termination of erasure and over-erasure mentioned above, according to one embodiment of the present invention each cell is erased individually. In another embodiment of this invention, a group of one or more cells on a word line are erased at once with no danger of under or over-erasure of each particular cell. Self-termination of the erase operation of each cell occurs when that cell's transistor becomes conductive, and at that time the erasure of only that cell ceases. The erasure of a particular cell ceases without effecting the erasure of operation of other cells. Therefore, the electrical erasure is self-limiting for each individual cell.

In accordance with another embodiment of this invention, a group of one or more cells on a bit line are erased at once with no danger of under or over-erasure of each particular cell.

BRIEF DESCRIPTION OF THE DRAWING

Figure 1a is a plane view of a typical EEPROM cell;

Figure 1b is a cross-sectional view taken long the line BB of Figure 1a.

Figure 1c is a cross-sectional view of the structure of Figure 1a taken along the line CC;

Figure 1d shows the symbolic representation of the floating gate memory cell 100 of Figure 1a;

Figure 2 is a schematic diagram of a typical prior art EEPROM array;

Figure 3 is a schematic diagram of a prior art EEPROM array during erase; and

Figure 4 is a schematic diagram of one EEPROM array constructed in accordance with this invention.

DETAILED DESCRIPTION

Prior art EEPROM devices, as discussed above, terminate erasure when current begins to flow in the erase or bit line of the memory array due to the erasure of a single cell, possibly resulting in incomplete erasure of the remaining cells of the array. In contrast, the present invention alleviates this problem of insufficient or over-erasure by allowing each cell along an individual bit line to be independently erased. However, each cell along a particular word line is erased along with the other cells along that particular word line without the danger of over or insufficient erasure.

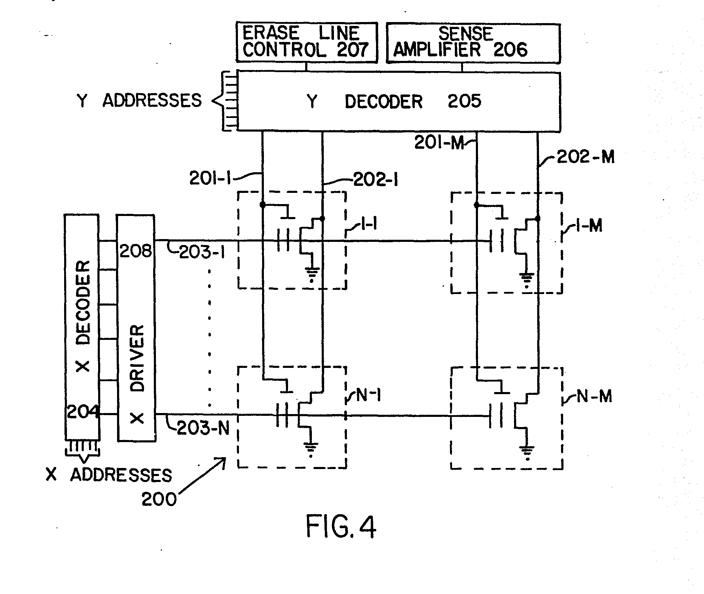

Figure 4 shows one embodiment of an EEPROM constructed in accordance with the principles of this invention. Memory array 200, of size NxM, includes erase lines 201, bit lines 202-1 through 202-M word lines 203-1 through 203-N, X decoder 204, Y decoder 205, sense amplifier 206, erase line control 207, X driver 208 and cells 1-1 through N-M. As in the circuit of Figure 2, N is the number of words in the array and M is the number of bits per word. In this embodiment of the invention, each individual cell is selectively erased without effecting the programmed state of any other cell. This is a significant improvement over prior art EEPROM arrays which required the simultaneous erasure of all cells along an entire word line.

In order to erase a desired cell, for example cell 1-1, the erase voltage pulse VE (typically 10-20 volts) is applied for a short period of time (i.e., typically 1 millisecond) through the Y decoder to the selected erase line 201-1 and to the selected bit line 202-1. The word line 203-1 corresponding to the cell 1-1 to be erased is held at a low voltage, typically ground. The remaining word lines 203-2 through 203-N do not contain cells which are to be erased and are held at a high voltage (typically 10-20 volts). This high voltage is capacitively coupled to the floating gates of the cells which are not to be erased, thereby reducing the voltage difference between the erase electrode and the floating gate of each cell which is not to be erased to a value below the voltage difference required to cause tunnelling between the floating gate and the erase terminal. Thus, all cells on deselected word lines 203-2 through 203-N are not erased.

A portion of the electrons held on the floating gate of cell 1-1 are injected from the floating gate to the erase line 201-1 of cell 1-1 in response to each erase voltage pulse. As this is done, cell 1-1 will, after a sufficient number of erase pulses, have its control gate threshold voltage reduced to a value corresponding to a logical one (i.e., a low impedance will exist between the source-drain regions of cell 1-1 in response to a voltage of approximately 5 volts applied to the control gate (word line 203-1) of cell 1-1). The erase state of each cell being erased is tested after each erase voltage pulse by suitable test circuitry preferably contained in the same integrated circuit device (not shown, but described in the aforementioned published European patent application). When it has been determined by such test circuitry that a cell being erased has in fact been erased, erasure of that cell stops by such test circuitry preventing additional erase pulses from being applied to its associated erase line (e.g., erase line 201-1 associated with cell 1-1).

In another embodiment of this invention, a plurality of cells along a selected word line are erased simultaneously, with each cell being erased being self-limited only by itself. Thus, when a first cell being erased along a selected word line is sufficiently erased (as determined after one or more erase pulses by suitable test circuitry, not shown), its associated erase line is prevented from receiving additional erase pulses, thereby preventing over-erasure of that cell, while allowing the remaining cells along the selected word lines which are to be erased to receive additional erase pulses. The circuit shown in the schematic diagram of Figure 4 is suitable for this purpose, merely by adapting Y decoder 205 to provide the erase voltage pulse VE to a selected plurality of erase lines 201-1 through 201-M simultaneously.

In another embodiment of this invention, a plurality of cells along a selected bit line are erased simultaneously, with each cell being erased being self-limited only by itself, thus, when a first cell being erased along a selected bit line is sufficiently erased (as determined after one or more erase pulses by suitable test circuitry, not shown), its associated word line is deselected, thereby preventing the erased cell from being further erased upon application of additional erase pulses to its erase line, thereby preventing over-erasure of that cell, while allowing the remaining cells on the selected bit line to be further erased upon receipt of additional erase pulses.

The present invention alleviates the problem of insufficient erasure by allowing each cell along either an individual bit line 202-1 through 202-M or along an individual word line 203-1 through 203-N to be independently erased. However, each cell along a particular bit line 202-1 through 202-M (or word line 203-1 through 203-N can be erased along with other selected cells along that particular bit line (or word line), because complete erasure of one of the cells does not result in a drop in the voltage along the other bit lines of the cells being erased.

While specific embodiments of this invention have been presented in the specification, these specific embodiments are intended to serve by way of example only and are not to be construed as limitations on the scope of this invention. Numerous other embodiments of this invention will become readily apparent to those with ordinary skill in the art in light of the teachings of this specification.

CLAIMS

1. A memory device comprising a plurality of N x M cells (1-1 to N-M), each cell capable of storing a single bit, said device comprising :

a plurality of N word lines (203-1 to 203-N);

a plurality of M bit lines (202-1 to 202-M);

a plurality of M erase lines (201-1 to 201-M);

wherein each said cell is associated with one of said plurality of N word lines, one of said plurality of M bit lines, and one of said plurality of M erase lines;

characterized in that at least one selected cell is erased by selecting the bit line associated with said at least one selected cell and de-selecting the remaining bit lines, selecting the word line associated with said at least one selected cell and de-selecting the remaining word lines, and applying a plurality of erase pulses to the erase line associated with said at least one selected cell, and in that the contents of each said selected cell is read after each of said plurality of erase pulses, and erasure of said each selected cell is stopped when the contents of said each selected cell has been erased.

2. The structure as in Claim 1, characterized in that each said cell comprises :

a drain connected to its associated bit line (202);

a source connected to a reference potential;

a floating gate;

a control gate connected to its associated word line (203) and;

an erase terminal connected to its associated erase line (201).

3. The structure as in Claim 1 or 2, characterized in that, during erasure, said word lines (203) are selected by the application of a low voltage and deselected by the application of a high voltage; and said bit lines (202) are selected by the application of a high voltage, and deselected by the application of a low voltage.

4. The structure as in anyone of claims 1 to 3, characterized in that said plurality of erase pulses are also applied to the bit line associated with said at least one selected cell.

5. The structure as in any one of claims 1 to 4, characterized in that one selected cell is erased at a time, and in that the erasure of said selected cell is stopped by terminating the application of said plurality of erase pulses when the content of said selected cell has been erased.

6. The structure as in any one of claims 1 to 4, characterized in that a plurality of cells associated with a specified word line are erased simultaneously and in that the erasure of each selected cell is stopped when said each selected cell has been erased by preventing said erase pulses to be applied to the erase line associated with said each erased selected cell,
whereby the erasure of each erased selected cell ceases without ceasing further erasure of the remaining cells being erased.

7. The structure as in any one of claims 1 to 4, characterized in that a plurality of cells associated with a specified bit line are erased simultaneously, and in that the erasure of each selected cell is stopped when said each selected cell has been erased by deselecting the word line associated with said each erased selected cell,

whereby the erasure of each erased selected cell ceases without ceasing further erasure of the remaining cells being erased.

FIG. 1a

FIG. 1b

FIG. 1d

FIG. 1c

300

FIG. 2

0108681

3/4

FIG. 3

FIG.4